# FASCICULE DE BREVET EUROPEEN

(11) **EP 2 577 396 B1**
(45) Date de publication et mention de la délivrance du brevet: **30.10.2019**
(21) Numéro de dépôt: 11721779.4
(22) Date de dépôt: 26.05.2011
(51) Int. Cl.: G03F 7/00

(54) **LITHOGRAPHIE PAR IMPRESSION NANOMETRIQUE**
NANOIMPRINTLITHOGRAPHIE
NANOIMPRINT LITHOGRAPHY

(30) Priorité: 28.05.2010 FR 1054169
(43) Date de publication de la demande: 10.04.2013
(73) Titulaire: Commissariat à l'Énergie Atomique et aux Énergies Alternatives, 75015 Paris (FR)
(72) Inventeur: PAULIAC, Sébastien, F-38000 Grenoble (FR); LANDIS, Stefan, F-38500 Voiron (FR)
(74) Mandataire: Hautier, Nicolas
(86) Numéro de dépôt international: PCT/EP2011/058697
(87) Numéro de publication internationale: WO 2011/147948

(56) Documents cités:
- WO-A1-2010/048988
- WO-A2-2005/029179
- JP-A- 2004 304 097
- US-A1- 2006 292 487
- US-A1- 2007 099 323
- US-A1- 2009 189 317
- US-A1- 2010 072 675
- XING CHENG, L. JAY GUO: "A combined nanoimprint-and-photolithography patterning technique", MICROELECTRONIC ENGINEERING, vol. 71, 2004, pages 277-282, XP002616560,

## Description

La présente invention concerne la lithographie pour la fabrication des circuits intégrés en général et plus particulièrement un procédé amélioré de lithographie par impression nanométrique.

La fabrication industrielle de nouvelles générations de circuits intégrés implique de pouvoir graver des motifs de tailles toujours plus petites et qui se mesurent maintenant en nanomètres (nm = 10⁻⁹ mètre). La photolithographie utilisée depuis l'origine, basée sur l'insolation de résines photosensibles à travers des masques optiques reproduisant les motifs à graver, se heurte cependant à des barrières physiques qui demandent d'avoir recours à des techniques de plus en plus sophistiquées pour pouvoir accompagner la croissance de la densité d'intégration souhaitée. Notamment, pour limiter la diffraction de la lumière au travers des masques on doit avoir recours à des longueurs d'ondes plus courtes (ultraviolet, voire rayons X) et à toutes sortes de techniques (par exemple, lithographie en immersion dans un liquide) qui demandent des investissements considérables pour leur développement et leur mise en œuvre industrielle.

Dès le milieu des années 90 une technique très différente, qui permet notamment de s'affranchir complètement des problèmes de diffraction mentionnés ci-dessus, a cependant été inventée par le Professeur Stephen Y. CHOU et ses collaborateurs travaillant alors à l'université du Minnesota aux États-Unis. Le principe en a été dévoilé dans un article intitulé « Imprint of sub-25 nm vias and trenches in polymers » publié dans « Appl. Phys. Lett. 67 (21) » en date du 20 novembre 1995, et dont les coauteurs sont : Peter R. Krauss, et Preston J. Renstrom. Plus connue sous son appellation générale, en anglais, de « nanoimprint lithography », c'est-à-dire : lithographie par impression nanométrique, cette technique fait désormais partie de la feuille de route internationale des technologies pour les semi-conducteurs ou ITRS « international technology roadmap for semiconductors ». Et plus particulièrement pour les technologies de circuits intégrés en cours de développement ou en phase d'industrialisation dont l'élément fonctionnel de base, le nœud, a été défini par la feuille de route successivement à 32 nm et à 22 nm.

La lithographie par impression nanométrique comprend deux techniques principales. La première, celle proposée à l'origine par le Professeur Chou, appelée T-NIL, de l'anglais pour « thermal nanoimprint lithography », c'est-à-dire lithographie par impression nanométrique thermique, consiste à imprimer, avec un moule opaque, des monomères ou des polymères thermoplastiques chauffés. Après refroidissement le moule peut être enlevé, les motifs imprimés restent en place. Cette technique est très simple à mettre en œuvre, mais les motifs ainsi créés ne sont pas directement transférables dans le ou les matériaux à graver. Pour cela, il faut aussi réaliser une gravure dite RIE de l'anglais « reactive ion etching », c'est-à-dire une gravure ionique réactive en présence d'oxygène afin d'enlever les résidus de monomères ou de polymères restant présents au fond des tranchées nano imprimées. Une autre voie consiste à effectuer des étapes de gravure au cours desquelles une épaisseur contrôlée de matériau est enlevée par voie chimique.

La seconde technique, désignée P-NIL consiste à imprimer une résine photosensible avec un moule transparent et à réaliser une insolation optique du film de résine au travers de celui-ci. L'insolation provoque la réticulation du film de résine qui se solidifie. Comme précédemment on peut alors retirer le moule. Cette technique laisse également un résidu au fond des motifs nano imprimés qu'il faut pouvoir enlever pour permettre le transfert des motifs sur le substrat que l'on désire graver.

Plusieurs solutions d'impressions nanométriques ont été proposées, parmi lesquelles celles mentionnées dans les documents suivants.

Les documents WO2005/029179, US 2006/292487, US2007/099323, JP 2004 304097, US2009/0189317 décrivent des procédés d'impressions nanométriques dans lesquels un moule présente des motifs dont les extrémités des reliefs sont recouvertes d'un revêtement de masquage. La publication "A combined nanoimprint-and-lithography patterning technique", Xing Cheng et L. Jay Guo, Microelectronic Engineering vol.71, 2004 décrit une technique similaire à celle du document WO2005/029179.

Le document WO 2010/048988 vise à obtenir un moule composite présentant des reliefs dont les extrémités sont recouvertes d'un revêtement de masquage. Pour obtenir ce moule composite, il est prévu de transférer une couche depuis un moule de base vers le moule composite. Le moule de base présente un élément de masquage recouvrant la résine en dehors des motifs.

Le document US 2010/0072675 décrit un procédé dans lequel un revêtement de masquage est incorporé à l'intérieur d'un moule de nanoimpression. Ainsi les reliefs du moule sont disposés entre le revêtement de masquage et la résine à imprimer.

La lithographie par impression nanométrique est une technique très intéressante pour toute l'industrie de la microélectronique. Elle permet de reproduire efficacement des motifs de tailles nanométriques, par exemple sur toute la surface des tranches de silicium utilisées par cette industrie pour produire des circuits intégrés en grandes quantités, avec un faible coût de mise en œuvre. Son principal inconvénient est, comme indiqué ci-dessus pour des résines standard, la présence de résidus après impression sur toutes les surfaces qui ont été compressées.

L'invention a donc pour objet d'apporter une solution à ce problème.

L'invention décrit un procédé de lithographie par impression nanométrique comportant une étape de préparation au cours de laquelle on dispose une résine sur un substrat, une étape de pressage d'un moule comportant des reliefs de sorte à transférer les reliefs du moule dans la résine pour y former des motifs, une étape de retrait pour séparer le moule de la résine, une étape d'insolation pour activer la résine, ladite étape d'insolation étant effectuée avant ou après l'étape de retrait du moule. La résine est une résine photosensible positive. Ce procédé comprend en outre, avant ou après l'étape de retrait du moule une étape d'exposition pour activer la résine. Il comprend également, préalablement à l'étape d'exposition, une étape de masquage au cours de laquelle on dispose entre le moule et la résine un revêtement de masquage stoppant en partie au moins l'exposition de la résine qu'il recouvre, le revêtement de masquage recouvrant la résine en dehors des extrémités des motifs.

De préférence, au moins lors de l'étape d'exposition, le revêtement de masquage laisse libre l'extrémité au moins des motifs et recouvre toute la résine située en dehors des motifs. Préférentiellement, au moins lors de l'étape d'exposition, le revêtement de masquage recouvre une partie au moins des flancs des motifs sur une hauteur strictement supérieure à l'épaisseur du revêtement de masquage.

Ainsi, le revêtement de masquage recouvre la résine sur les zones ne constituant pas un motif et laisse libre la résine sur les motifs, au moins à leurs extrémités.

Par conséquent, lors de l'étape d'insolation, la zone non recouverte par le revêtement de masquage est insolée. La résine laissée libre est alors activée. Elle peut être développée sans laisser subsister de résidus dans le fond des motifs. L'invention permet par conséquent de faire disparaître ces résidus sans avoir recours à une étape de type gravure ionique réactive (RIE).

Par résine positive, on entend une résine à base d'une matrice de polymères contenant au moins un photogénérateur d'acides, en général connu sous la dénomination de PAG pour son appellation anglo-saxone photo acid generator. Lors de l'insolation, le PAG libère des acides qui rompent les liaisons entre les polymères, permettant ainsi le développement de la résine.

L'invention peut être réalisée notamment avec les résines positives standard utilisées en microélectronique, en photolithographie, par exemple des résines positives à amplification chimique (non liquides). L'insolation peut avoir lieu à l'échelle de la tranche également désigné wafer, c'est-à-dire collectivement sur toute la tranche, ce qui limite son coût.

Le procédé selon l'invention a également pour avantage de réduire les risques de formation de pieds dans le fond des motifs obtenus dans la résine. On désigne par pied un angle de résine qui demeure de manière non souhaitée dans le fond d'un motif. Plus la résolution est élevée, plus les pieds déforment les motifs souhaités. Avec le procédé selon l'invention l'insolation a tendance à être plus importante au niveau du fond des motifs qu'à la surface de la résine du fait de phénomènes de diffusion et/ou de diffraction. Toute la zone que l'on souhaite insoler est alors effectivement insolée et la formation de pied est évitée.

De manière facultative, le procédé comprend au moins l'une quelconque des caractéristiques optionnelles suivantes :
- Le revêtement de masquage recouvre toute la résine située en dehors des motifs ainsi qu'une partie au moins des flancs des motifs de sorte à ce que la partie des flancs recouverte s'étende au-delà du revêtement de masquage recouvrant la résine en dehors des motifs.
- De préférence, le revêtement de masquage recouvre les flancs du motif sur une hauteur supérieure à l'épaisseur du revêtement de masquage. Préférentiellement, la hauteur recouverte par le revêtement de masquage est au moins égale à 1.5 voire à deux fois l'épaisseur de la couche formant le revêtement de masquage. L'épaisseur de cette couche est prise sur une zone dépourvue de motifs. La hauteur recouverte se mesure par exemple depuis la face du revêtement de masquage tournée au regard de la résine.
- La partie de revêtement de masquage qui recouvre les flancs des motifs s'étend selon une direction sensiblement parallèle aux motifs. Si les motifs forment des tranchées présentant des flancs sensiblement perpendiculaires au plan du substrat, cette portion de revêtement de masquage s'étend alors également selon une direction sensiblement perpendiculaire au plan du substrat.
- De préférence, pour chaque motif, le revêtement de masquage recouvre les flancs du motif sur une hauteur environ égale au tiers de la largeur du motif. Avantageusement, lors de l'étape d'exposition, pour chaque motif, les flancs du motif sont recouverts sur une hauteur au moins égale à la moitié de la largeur du motif.
- De préférence, le revêtement de masquage recouvre toute la surface de la résine en dehors de l'extrémité des motifs et éventuellement d'une partie des flancs des motifs.
- Avantageusement, le recouvrement des flancs par le revêtement de masquage permet d'obtenir un meilleur rapport de forme et d'obtenir des motifs étroits tout en limitant la formation de pieds dans le fond des motifs.
- Dans certains modes de réalisation non limitatifs, le revêtement de masquage recouvre au moins 20 % de la hauteur du motif. Encore plus avantageusement, le revêtement de masquage recouvre au moins 50 % voire au moins 80 % de la hauteur du motif.
- De préférence, le revêtement de masquage recouvre toute la surface du moule en dehors de l'extrémité des reliefs et éventuellement d'une partie des flancs des reliefs.
- Le revêtement de masquage présente une face interne tournée au regard de la résine au moins lors de l'étape de pressage. Au moins lors de l'étape de pressage, le revêtement de masquage au contact des flancs des motifs s'étend au-delà de ladite face interne.
- De préférence, l'étape d'insolation est une étape d'insolation optique. De manière alternative, cette étape est une étape d'exposition à un flux d'électrons et/ou d'ions. Selon une autre alternative, la résine est exposée par une étape d'insolation optique et par une étape d'exposition à un flux d'électrons et/ou d'ions.
- Le procédé comprend une étape de développement de la résine après les étapes d'insolation et de retrait du moule. Ainsi, dans le cas d'une résine positive, les résidus de résine situés dans le fond des tranchées sont supprimés et le substrat est mis à jour.
   Dans un premier mode de réalisation, lorsque le revêtement de masquage est appliqué sur la résine avant l'étape de pressage du moule, les reliefs du moule traversent le revêtement de masquage pour pénétrer dans la résine lors de l'étape de pressage.
- L'étape d'insolation est effectuée après l'étape de retrait du moule. A cet effet on prévoit de préférence un moule réalisé dans un matériau opaque. De manière alternative, l'étape d'insolation peut être effectuée avant l'étape de retrait du moule si ce dernier est transparent au rayonnement de l'insolation.
- Le procédé comprend une étape de développement de la résine après les étapes d'insolation et de retrait du moule dans lequel le revêtement de masquage est développable et disparaît lors de l'étape du développement de la résine. Avantageusement, les résidus de résine situés dans le fond des motifs et le revêtement de masquage sont supprimés au cours d'une même étape de développement. De manière alternative, l'étape de développement fait disparaître la résine insolée lors de l'étape d'insolation et laisse en place le revêtement de masquage.
- L'épaisseur de la résine est au moins trois fois supérieure à l'épaisseur du revêtement de masquage. De préférence, la hauteur des motifs est au moins deux fois supérieure à l'épaisseur du revêtement de masquage. De préférence, la hauteur des reliefs est au moins deux fois supérieure à l'épaisseur du revêtement de masquage. De préférence, les reliefs pénètrent d'environ au moins une fois l'épaisseur du revêtement de masquage au delà de la surface libre du revêtement de masquage. Ces dimensions relatives permettent une bonne pénétration des reliefs est un bon dégagement du revêtement de masquage.

- La résine a une tonalité positive. Dans un mode de réalisation avantageux, la résine est de type CR01P et le revêtement de masquage est en Barc DUV30. Dans un autre mode de réalisation avantageux, la résine est de type M78Y et le revêtement de masquage est en AISi. Dans un premier mode de réalisation, le moule est réalisé dans un matériau qui laisse passer au moins en partie le rayonnement lors de l'étape d'insolation. Le revêtement de masquage est alors appliqué sur le moule avant pressage du moule dans la résine et l'étape d'insolation est effectuée avant l'étape de retrait et au travers du moule. De préférence, le revêtement de masquage est disposé sur la face du moule destinée à être pressée contre la résine. Ainsi, le moule est associé au revêtement de masquage. Une unique étape de pressage permet à la fois d'imprimer les reliefs et d'appliquer sur la résine un masque bloquant le rayonnement sur des zones définies par le revêtement de masquage.
- De préférence, on effectue une étape de chauffage de la résine préalablement à l'étape de pressage du masque. Cette étape de chauffage facilite la pénétration du moule dans la résine. La température de chauffe est supérieure ou égale à la température de transition vitreuse de la résine mais demeure inférieure à sa température de déprotection.
- Après l'étape de pressage et après l'étape d'insolation, on effectue une étape de développement de la résine pour retirer les résidus de résine. De préférence, cette étape de développement est effectuée avec recuit préalable. Alternativement, elle est effectuée sans recuit préalable.
- Le revêtement de masquage est formé d'une seule couche ou d'une pluralité de couches. Avantageusement, le revêtement de masquage est en chrome.
- Le revêtement de masquage peut éventuellement être recouvert d'un matériau antiadhésif pour faciliter le retrait du moule.
- Le revêtement de masquage est appliqué sur le moule de sorte à laisser les reliefs libres au moins à leur extrémité pour permettre une insolation de la résine à travers les reliefs du moule. Si seulement l'extrémité du relief est laissée libre, on obtiendra une résolution particulièrement bonne des motifs.
- Les flancs latéraux des reliefs sont en partie au moins recouverts par le revêtement de masquage. On obtient alors, après insolation et développement de la résine, un motif sensiblement trapézoïdale et plus généralement un motif présentant une dimension plus importante au fond de la résine qu'en surface de résine, formant ainsi une cavité dans le fond des motifs. Cela a pour avantage de faciliter une opération ultérieure habituellement désignée par le vocable anglais de « lift-off » et qui consiste à former un motif par soulèvement en attaquant une couche sous-jacente. La réalisation de certaines structures nécessite de déposer une couche de métal par exemple dans le fond des motifs de la résine. A cet effet, selon les procédés connus on dépose sur toute la surface de la résine et au droit des ouvertures une couche de métal. Dans certains cas, la couche de métal peut adhérer au moins en partie au flanc des motifs, empêchant de ce fait un dépôt approprié dans le fond des motifs à l'aplomb de l'ouverture. Les procédés existants prévoient une étape ultérieure de retrait de la résine au cours de laquelle le métal présent en surface de la résine est retiré pour ne laisser subsister que le métal présent au fond des ouvertures. Dans les cas où une partie de la couche de métal adhère aux flancs ou n'est pas correctement positionnée sur le fond du motif, le résultat final est insatisfaisant.

Le procédé selon l'invention, en formant des cavités dans le fond des motifs, favorise une rupture de la couche de métal au niveau du fond des motifs et un dépôt correcte du métal sur le fond du motif au droit de l'ouverture. Le métal ne recouvre pas toute la surface de la cavité mais recouvre bien toute la zone située au droit de l'ouverture. L'étape ultérieure de retrait de la résine emmène le métal présent en surface de la résine et ne laisser subsister que le métal présent au fond des ouvertures. Le résultat final est significativement amélioré par rapport aux procédés connus.

L'invention a également pour objet un ensemble multi couches selon la revendication 9.

L'invention a aussi pour objet un moule pour procédé de lithographie par impression nanométrique selon la revendication 10.

Le revêtement de masquage stoppe le rayonnement optique en dehors du au moins un relief et laisse passer le rayonnement au niveau des reliefs. Il laisse donc libre l'extrémité du au moins un relief. Selon une première variante de ce mode de réalisation, le revêtement de masquage recouvre toute la hauteur des flancs du motif et laisse libre uniquement l'extrémité des motifs. Selon une deuxième variante de ce mode de réalisation, le revêtement de masquage laisse les flancs du relief libres sur une partie seulement de leur hauteur.

De préférence, le revêtement de masquage recouvre les flancs du relief sur une hauteur supérieure à l'épaisseur du revêtement de masquage. Préférentiellement, la hauteur recouverte par le revêtement de masquage est au moins égale à deux fois l'épaisseur de la couche formant le revêtement de masquage. L'épaisseur de cette couche est prise sur une zone du moule dépourvue de reliefs.

Avantageusement, le recouvrement des flancs par le revêtement de masquage permet d'obtenir un meilleur rapport de forme et d'obtenir des motifs étroits tout en limitant la formation de pied dans le fond des motifs.

Avantageusement, le revêtement de masquage recouvre au moins 20 % de la hauteur du relief. Encore plus avantageusement, le revêtement de masquage recouvre au moins 50 % voire au moins 80 % de la hauteur du relief.

De préférence, le revêtement de masquage recouvre toute la surface du moule en dehors de l'extrémité des reliefs et éventuellement d'une partie des flancs des reliefs.

De préférence, le revêtement de masquage est recouvert d'un matériau antiadhésif. Cette caractéristique permet de faciliter le retrait du moule.

L'invention a également pour objet un procédé de fabrication d'un moule selon l'un quelconque des modes de réalisation de l'invention. Ce procédé est conforme à la revendication 17.

De manière facultative, le procédé de fabrication comprend au moins l'une quelconque des caractéristiques optionnelles suivantes :
- Préalablement à l'étape de masquage, le procédé comprend une étape d'obtention d'au moins un relief sur ladite face du substrat pour former un moule de base et l'étape de retrait partiel consiste à retirer le revêtement de masquage au niveau des extrémités au moins dudit au moins un relief. De manière facultative, l'étape de retrait partiel supprime le revêtement de masquage uniquement au niveau de l'extrémité du au moins un relief et le procédé comprend une étape d'extension dudit au moins un relief, l'étape d'extension comprenant une sous étape consistant à recouvrir le revêtement de masquage et l'au moins un relief par un matériau additionnel transparent au rayonnement optique, une sous étape de lithographie consistant à supprimer le matériau additionnel en dehors du au moins un relief et à le conserver au niveau du au moins un relief pour former une extension du au moins un relief. De manière préférée, ce procédé comprend une étape consistant à ajuster la hauteur de l'extension. De préférence, cette étape d'ajustement résulte d'une planarisation ou polissage mécano chimique.
- Après l'étape de retrait partiel, le procédé prévoit une étape de recouvrement du substrat au niveau de ladite zone non recouverte et du revêtement de masquage par un matériau additionnel transparent au rayonnement optique et comprend une étape de lithographie pour former dans le matériau additionnel au moins un relief au niveau de ladite zone non recouverte par le revêtement de masquage.

D'autres caractéristiques, buts et avantages de la présente invention apparaîtront à la lecture de la description détaillée qui va suivre, et en regard des dessins annexés, donnés à titre d'exemples non limitatifs et sur lesquels :
La figure 1 montre le principe général du procédé de lithographie par impression nanométrique et insolation selon l'invention.
Les figures 2a à 2f décrivent un premier mode de mise en œuvre de l'invention dans lequel le revêtement de masquage de la résine photo sensible sous-jacente est déposé sur la résine elle-même.
Les figures 3a à 3d décrivent un deuxième mode de mise en œuvre de l'invention dans lequel le masque optique fait partie intégrante du moule d'impression.
Les figures 4a, 4b et 4c montrent différentes structures de moules qui peuvent être utilisés pour la mise en œuvre du deuxième mode de réalisation dans lequel la résine utilisée est positive.
Les figures 5a à 5e décrivent le mode d'obtention d'un moule de type A.
Les figures 6a à 6g décrivent les étapes du mode d'obtention d'un moule de type B.
Les figures 7f à 7i décrivent les étapes supplémentaires du mode de réalisation d'un moule de type C par rapport à celles d'un moule de type A.

Les dessins joints sont donnés à titre d'exemples et ne sont pas limitatifs de l'invention.

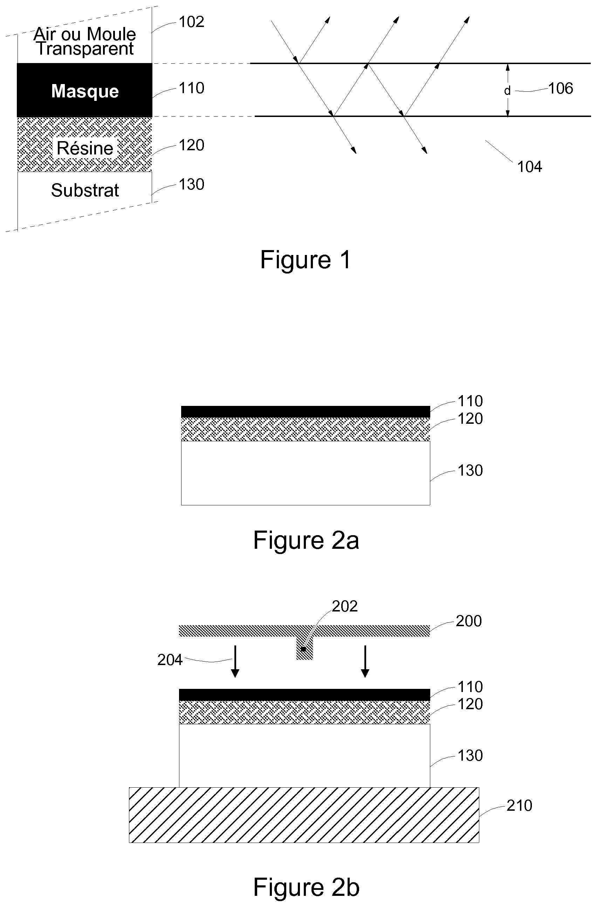

La figure 1 montre le principe général du procédé de lithographie par impression nanométrique et insolation selon l'invention. Procédé dans lequel l'impression des motifs est faite à partir d'un moule dans une résine photosensible 120 qui aura préalablement été déposée sur le substrat 130 à graver. La résine photosensible 120 a une tonalité positive. De préférence un motif forme un creux dans la résine. L'invention prévoit qu'un masque optique, sous forme d'une couche totalement ou partiellement opaque, est aussi présent. Le masque pourra avoir été déposé et formé sur la couche de résine ou fera partie intégrante d'un moule transparent selon les différents modes de mise en œuvre de l'invention décrits dans les figures suivantes.

L'invention ne fait pas d'hypothèse sur le mode de dépôt de la résine et, éventuellement, du masque. Toutes les techniques connues et employées notamment par l'industrie de la microélectronique sont susceptibles d'être utilisées, des plus simples comme le dépôt par centrifugation ou « spin-coating », souvent utilisé pour le dépôt des résines photosensibles, aux plus élaborées des techniques de dépôt, par exemple dans une chambre de confinement par évaporation thermique d'un matériau approprié, sous vide ou en présence de gaz réactifs. Cette couche formant le masque optique sera par la suite désignée revêtement de masquage 110.

La gravure du substrat, but final de toute opération de photogravure, n'est pas autrement décrite. Là aussi, toutes les techniques mises en œuvre par l'industrie de la microélectronique pour graver les substrats à chacune des très nombreuses étapes de réalisation des nombreux types de dispositifs produits par cette industrie : circuits intégrés, composants optoélectroniques, nano structures mécaniques et autres, sont possibles.

L'optimisation de l'opacité du masque pour la couche de résine sous-jacente 120, soumise à une insolation depuis une source lumineuse à travers un moule transparent ou dans l'air, pourra se faire en utilisant toutes les méthodes de calcul mises au point pour les dispositifs optiques stratifiés du type interféromètre de Fabry-Pérot 104 bien connu par les spécialistes de ce domaine. La couche supérieure à considérer 102, est selon l'une ou l'autre des mises en œuvre décrites ci-après, de l'air ou le matériau transparent dans lequel le moule d'impression est fabriqué. Des coefficients de réflexion et de transmission seront facilement établis, notamment en fonction de l'épaisseur de la couche formant le revêtement de masquage 106 et de sa composition, qui permettront son optimisation afin de pouvoir maintenir la dose d'énergie reçue par la résine, dans les zones restant protégées par le masque, sous une valeur de seuil caractéristique de la résine employée. Valeur inférieure à un seuil généralement désigné par le vocable anglais de « dose to clear », c'est-à-dire dose nécessaire à la transformation de la résine afin d'obtenir son changement de comportement. Ainsi, tant que ce seuil n'est pas franchi, cela garantit qu'une résine de tonalité positive, initialement insoluble, reste insoluble, et qu'une résine de tonalité négative reste soluble après l'opération d'insolation décrite ci-après.

Les figures 2a à 2f, décrivent un premier mode de mise en œuvre de l'invention. Dans ce mode de réalisation le revêtement de masquage 110 de la résine 120 photosensible sous-jacente est déposée sur la résine 120 comme illustré sur la figure 2a.

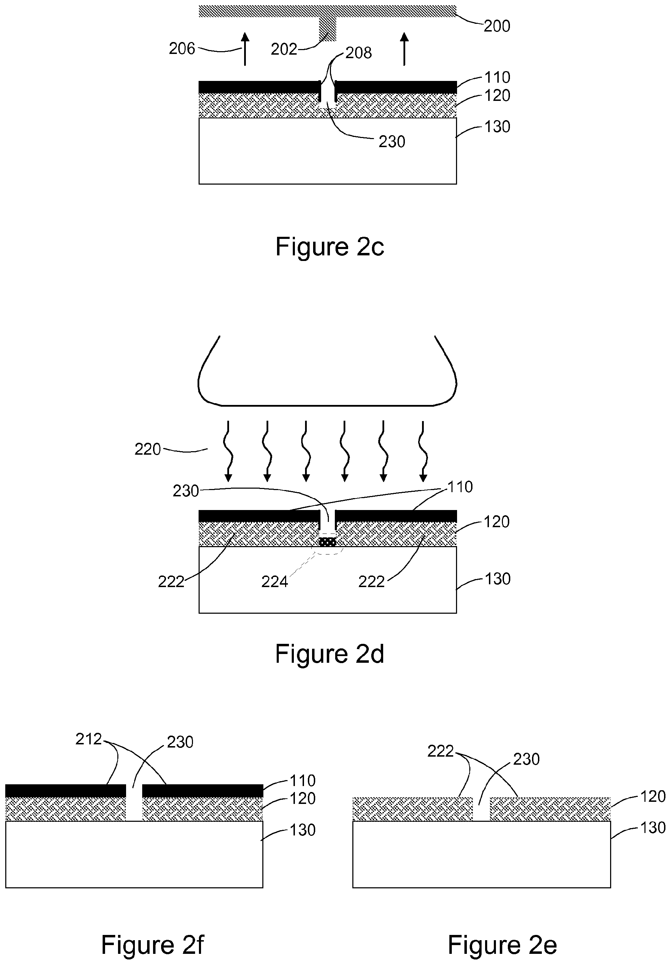

Comme schématisé sur la figure 2b, c'est cet empilement de couches qui sera imprimé par pressage du moule 200 dans lequel tous les reliefs 202 à reproduire ont été gravés. Préalablement à l'opération d'impression, qui demande qu'une forte pression 204 soit exercée pour imprimer les reliefs 202 du moule 200 pour former les motifs 230 dans la couche de résine 120, à travers le revêtement de masquage 110, le substrat 130 pourra être placé sur un appareillage de chauffage 210 adéquat jusqu'à ce que les couches superficielles 110, 120 acquièrent une température propice à favoriser l'opération de pressage tout en restant inférieure à la température dite de « déprotection » de la résine 120 qui la rendrait inutilisable. Avantageusement, la température de chauffe sera supérieure ou égale à la température de transition vitreuse de la résine.

Dans le cadre de la présente invention, et pour tous les modes de réalisations décrits, on désigne par relief(s) et motif(s), aussi bien des saillies que des creux. Un même moule et une même couche de résine peuvent présenter une ou plusieurs saillies et un ou plusieurs creux. De préférence et comme illustré, le relief du moule forme une saillie et le motif imprimé dans la résine forme un creux dans la résine correspond au relief du moule comme illustré sur les figures.
La figure 2c montre le résultat de l'opération d'impression après que l'on a laissé refroidir le substrat 130 et les couches de résine 120 et de masquage 110 pour permettre le retrait 206 du moule 200 sans déformation des motifs 230 imprimés dans la résine 120. Dans ce premier mode de mise en œuvre le moule 200 sert donc aussi à former le revêtement de masquage 110 en perforant la couche correspondante 110. Le matériau qui la constitue est donc choisi pour non seulement satisfaire les propriétés optiques discutées précédemment mais pour avoir aussi les propriétés mécaniques qui permettent sa déformation sans dommage pour l'intégrité des motifs 230. Le revêtement de masquage 110 sera avantageusement une couche métallique ou un assemblage stratifié de matériaux suffisamment ductiles pour que l'essentiel des parties perforées se replie sur les flancs des motifs 208 en ne laissant que peu ou pas de résidus dans le fond des motifs imprimés. On pourra avantageusement optimiser les épaisseurs relatives de la résine et du revêtement de masquage pour que en fonction de la taille des motifs et de la pression appliquée, la rupture de la couche de masquage soit optimisée. On pourra également jouer sur la forme des motifs, en utilisant des motifs trapézoïdaux, voire triangulaires.

Lors de l'étape de pressage, une partie du revêtement de masquage 110 se déchire sous l'effet de la pénétration des reliefs 202 du moule 200. Localement, le revêtement de masquage 110 se déforme est épouse les formes des reliefs 202. Comme illustré en figures 2c et 2d, le revêtement de masquage 110 recouvre ainsi les flancs des reliefs 202 ainsi que les flancs des motifs 230 définis par les reliefs 202.

Le revêtement de masquage 110 s'étend ainsi sur les flancs des motifs sur une hauteur supérieure à l'épaisseur de la couche formant le revêtement de masquage 110. Cette épaisseur peut être mesurée préalablement à l'étape de pressage ou entre deux motifs, là où le revêtement de masquage 110 n'est pas déformé lors de l'étape de pressage.

De préférence, cette hauteur de couverture des flancs est supérieure au tiers de la largeur des motifs. La largeur des motifs est prise selon une direction sensiblement parallèle à la surface de la couche de résine ou de la couche de revêtement de masquage 110. De manière encore plus préférée, la hauteur recouverte par les flancs est d'environ la moitié de la largeur des motifs.

Le revêtement de masquage 110 présente une face externe et une face interne tournées respectivement vers l'extérieur et vers l'intérieur de l'ensemble multicouches. Après perforation, les portions de revêtement de masquage 110 au contact des flancs s'étendent au-delà de la face interne.

Typiquement et sans que cela ne soit limitatif, l'épaisseur du revêtement de masquage 110 est comprise entre 5nm et 100nm. On veillera à adapter l'épaisseur en fonction du matériau du revêtement de masquage, de la profondeur de la résine, des dimensions du motif etc.

En ce qui concerne l'épaisseur minimale, cette couche doit en tout état de cause être suffisamment épaisse pour assurer son rôle de masque et absorber suffisamment le rayonnement UV pour que la résine sous-jacente ne soit pas rendue soluble et développée par la suite.

En ce qui concerne l'épaisseur maximale, elle ne doit pas être trop grande afin de permettre sa perforation lors de l'emboutissage. Elle doit être suffisamment faible par rapport aux dimensions du motif pour ne pas se retrouver au fond du trou après emboutissage mais bien sur les flancs.

La figure 2d décrit l'opération suivante où l'ensemble multicouches 110, 120, 130 est exposé sur toute sa surface à un rayonnement lumineux 220 dont la longueur d'onde est adaptée au type de résine photo sensible utilisée. Cela peut-être, par exemple, un rayonnement ultraviolet. Une exposition à un flux d'électrons ou d'ions peut être envisagée. Comme discuté précédemment les parties du revêtement de masquage 110 qui restent en place après impression protègent suffisamment la résine 120 sous-jacente pendant toute la durée de l'insolation. Le comportement de la résine 120 n'est pas modifié en ces zones 222 recouvertes par le revêtement de masquage 110. Seules les parties de la résine qui ont été comprimées par les reliefs 202 du moule 200 au cours de l'étape de pressage sont exposées directement au rayonnement lumineux. Ces zones non recouvertes 224 par le revêtement de masquage 110 reçoivent une dose de rayonnement suffisante pour franchir le seuil mentionné ci-dessus où le comportement de la résine est modifié ce qui va permettre son élimination à l'étape suivante.

On notera que la résine 120 employée est du type dit positif. Une résine de tonalité positive étant initialement insoluble son exposition au dessus du seuil de transformation la rend soluble ce qui permet, comme souhaité, son élimination à l'étape suivante dont le résultat est décrit avec la figure 2f ou 2e. On notera aussi que la faible quantité de résidus résultant de la perforation du revêtement de masquage 110 et qui pourrait être présente au fond des motifs 230 ne peut empêcher une insolation satisfaisante de ces motifs.

On remarquera également que le moule 200 n'est pas nécessairement transparent dans ce mode de mise en œuvre de l'invention puisque l'on procède au retrait du moule 200 avant insolation. Optionnellement, le moule 200 pourra cependant être réalisé dans un matériau transparent auquel cas l'insolation de la résine 120 pourra aussi se faire avant retrait du moule 200.

La dernière étape consiste à développer la résine 120 c'est-à-dire à la rendre soluble, là où elle a été exposée à un rayonnement suffisant. Les parties de résine non exposées 222 restent en place pour permettre la gravure du substrat 130 après que la résine compressée au fond des motifs 230 a été éliminée résolvant ainsi le problème objet de l'invention. Cette étape pourra nécessiter un recuit préalable.

On notera enfin, que comme montré sur la figure 2f les parties 212 du revêtement de masquage 110 qui n'ont pas été perforées par le moule peuvent optionnellement rester en place sans inconvénient pour la gravure du substrat 130. Cela, en fonction des matériaux utilisés pour cette couche et de la possibilité de l'éliminer ou pas lors de l'opération précédente de développement de la résine.

Le tableau ci-après donne deux exemples de matériaux et épaisseurs utilisés pour la réalisation de ce premier mode de mise en œuvre de l'invention :

| | Revêtement de masquage : | | Résine : | |
|---|---|---|---|---|
| | matériau | épaisseur | matériau | épaisseur |
| ex. n°1 | BARC DUV30 | 45 nm | CR01P | 140 nm |
| ex. n°2 | AlSi | 20 nm | M78Y | 800 nm |

En ce qui concerne le revêtement de masquage :
- Le matériau dénommé BARC, de l'anglais « bottom anti-reflective coating » est un produit de revêtement anti-réfléchissant largement utilisé en photolithographie par toute l'industrie de la microélectronique ; produit disponible commercialement sous la référence DUV30 auprès de fournisseurs spécialisés tel que Brewer Science, Inc.
- Dans l'exemple n°2 le revêtement de masquage est fait d'un alliage d'aluminium (Al) et de silicium (Si).

Dans les deux exemples les résines positives utilisées sont aussi des produits largement utilisés en photolithographie: la résine CR01P est disponible commercialement auprès de la société Tokyo Ohka Kogyo CO., Ltd et la résine M78Y auprès de la société JSR Electronics NV.

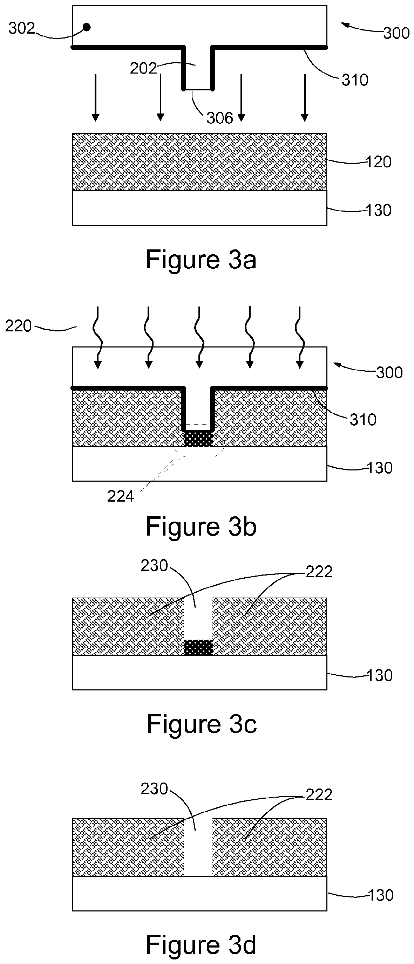

Les figures 3a à 3d décrivent un deuxième mode de mise en œuvre de l'invention dans lequel le revêtement de masquage 310 fait partie intégrante du moule.

Dans ce cas on a recours à un moule 300 qui est fait d'un matériau transparent 302 également désigné moule de base 302, 502. Pour obtenir un résultat similaire à ce qui est décrit dans la figure 2 sans avoir à déposer pardessus la résine un revêtement de masquage celui-ci est placé sur le moule de base 302 lui-même. Le revêtement de masquage 310 du moule 300 couvre toutes les parties qui doivent être opaques afin de protéger, comme précédemment, la résine sous-jacente sur le substrat. Dans le cas d'utilisation d'une résine de tonalité positive, seules les extrémités 306 des reliefs 202 du moule 300 ne sont pas couvertes par le revêtement de masquage 310.

L'opération d'impression se fait comme précédemment mais dans la résine 120 seule. Comme montré sur la figure 3b les parties 224 de résine 120 comprimées par le moule 300 sont alors insolées 220 au dessus de leur seuil de transformation à travers le moule transparent qui reste en place pour cette opération puisqu'il sert aussi de masque pour les parties 222 non insolées de la résine 120. Comme précédemment, et dans les mêmes conditions, la résine 120 pourra être chauffée pour faciliter l'impression des motifs.

Après retrait du moule 300 la résine 120 reste en place comme illustré sur la figure 3c. Les parties comprimées 224 qui ont été insolées et rendues solubles peuvent alors être développées et éliminées dans les conditions standard de la lithographie optique classique. On prévoit par exemple un développement chimique pour retirer les résidus, avec ou sans recuit préalable.

Le résultat final est conforme à la figure 3d, et aux figures précédentes 2e et 2f, qui montrent que les résidus d'impression ont été éliminés au fond des motifs 230 et que l'on peut procéder directement à la gravure du substrat sans avoir recours à l'étape de gravure ionique réactive dite RIE mentionnée dans l'introduction sur l'état de la technique.

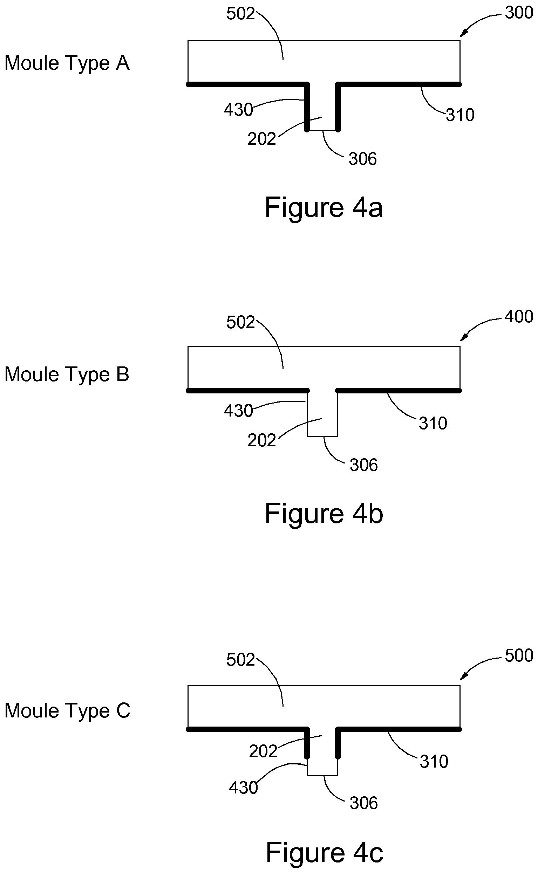

Les figures 4a, 4b et 4c montrent différentes structures de moules qui peuvent être utilisés pour la mise en œuvre du deuxième mode de réalisation décrit en référence aux figures 3a à 3d. Ce mode prévoit préférentiellement l'utilisation d'une résine positive. Chacun de ces moules 300, 400, 500 combine un substrat transparent 502 et un revêtement de masquage 310 bloquant le rayonnement.

La figure 4a reprend pour comparaison la structure de moule utilisée dans la figure 3 où seules les extrémités 306 des reliefs 202 du moule 300 ne sont pas masquées par le revêtement de masquage 310. Ce moule est désigné comme étant de type A dans la description qui suit de l'invention. Ce moule est particulièrement avantageux pour obtenir des motifs très fins.

La figure 4b montre que l'on peut aussi ne pas masquer les flancs 430 des reliefs 202 du moule 400.

La moule 500 illustré en figure 4c est un mode de réalisation avantageux dans lequel seule une partie des flancs 430 des reliefs 202 est masquée.

Les flancs 430 du relief 202 du moule 500 de type C illustré en figure 4c sont dépourvus de revêtement de masquage 310 uniquement partiellement, la portion des flancs 430 dépourvue de revêtement de masquage 310 s'étendant depuis l'extrémité 306 du relief 202.

De préférence, le revêtement de masquage 310 recouvre les flancs 430 du relief 202 sur une hauteur supérieure à l'épaisseur du revêtement de masquage 310. Préférentiellement, la hauteur recouverte par le revêtement de masquage 310 est au moins égale à 1.5 voire à deux fois l'épaisseur de la couche formant le revêtement de masquage 310. L'épaisseur de cette couche est prise sur une zone du moule dépourvue de reliefs.

Le revêtement de masquage 310 présente une face externe et une face interne tournées respectivement vers l'extérieur et vers l'intérieur du moule 500. Les portions de revêtement de masquage 310 au contact des flancs s'étendent au-delà de la face externe.

A titre d'exemple non limitatif, l'épaisseur de la couche formant le revêtement de masquage 310 est comprise entre 5nm à 1 micron.

En ce qui concerne l'épaisseur minimale, cette couche doit en tout état de cause être suffisamment épaisse pour assurer son rôle de masque et absorber suffisamment le rayonnement UV pour que la résine sous-jacente ne soit pas rendue soluble et développée par la suite. Cette épaisseur minimale dépend ainsi de la nature du matériau et de l'intensité du rayonnement.

Concernant l'épaisseur maximale, on veillera à ce qu'elle permette de déposer de manière uniforme le matériau du revêtement de masquage 310, l'épaisseur étant limitée par la profondeur du motif à réaliser.

Avantageusement, le recouvrement des flancs par le revêtement de masquage 310 permet d'obtenir un meilleur rapport de forme et d'obtenir des motifs plus étroits qu'avec un masque dans lequel les flancs ne sont pas recouverts, tout en limitant la formation de pied dans le fond des motifs.

Le moule de la 4c permet également de faciliter l'obtention des motifs de forme trapézoïdale et plus généralement présentant une dimension plus importante au fond des motifs qu'à la surface de la résine, ce qui s'avère particulièrement avantageux comme indiqué précédemment.

Avantageusement, le revêtement de masquage 310 recouvre au moins 20% de la hauteur du relief. Encore plus avantageusement, le revêtement de masquage 310 recouvre au moins 50 % voire au moins 80 % de la hauteur du relief.

En outre, l'obtention de ce type de moule peut être aisé, en utilisant par exemple une technique de projection du matériau formant le revêtement de masquage selon une direction oblique à la normale au substrat.

Préférentiellement, dans chacun de ces moules le revêtement de masquage 310 recouvre toute le moule en dehors des reliefs 202.

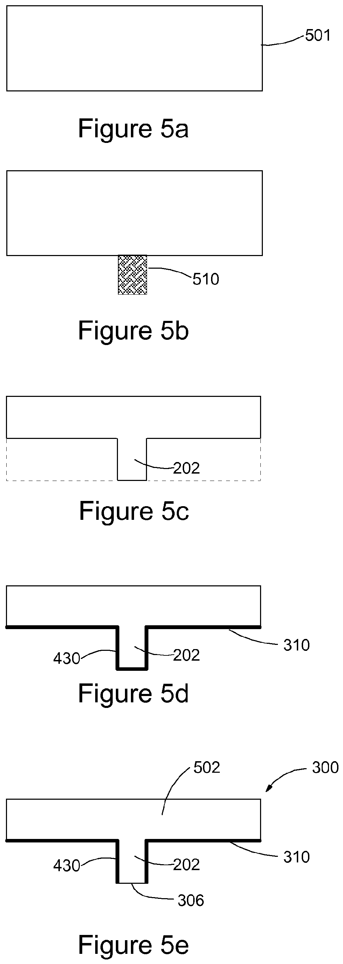

Les figures 5a à 5e décrivent un exemple de mode d'obtention d'un moule de type A.

Ce type de moule est fabriqué dans un bloc 501 de matériau transparent, par exemple du quartz, dans lequel on va former les reliefs 202 du moule avec les méthodes classiques de lithographie. A cette fin on dépose de la résine 510 et on délimite des reliefs. On réalise ensuite une étape de gravure et éventuellement une étape de nettoyage du bloc 501 afin d'obtenir un moule standard de type NIL. Cette étape de gravure est illustrée en figure 5c.

Une couche ou une combinaison de couches d'un ou plusieurs matériaux constituant le revêtement de masquage 310 opaque est déposée, en une ou plusieurs étapes, sur toute la surface gravée du moule de base gravé de façon à obtenir une épaisseur homogène y compris sur les flancs 430 des reliefs 202. On obtient alors le moule gravé et recouvert illustré en figure 5d. Le matériau déposé est par exemple du chrome.

Afin d'obtenir un moule de type A il suffit ensuite d'enlever le revêtement de masquage 310 sur les extrémités 306 des reliefs 202. Cette opération se fait simplement en utilisant l'une ou l'autre des méthodes de polissage couramment utilisées par l'industrie de la microélectronique pour abraser et polir les substrats et notamment en ayant recours au type de polissage classique dit mécano chimique connu sous le sigle CMP, de l'anglais « chemical mechanical polishing ». On obtient ainsi un moule 300 par association d'un substrat 502 transparent et d'un revêtement de masquage 310.

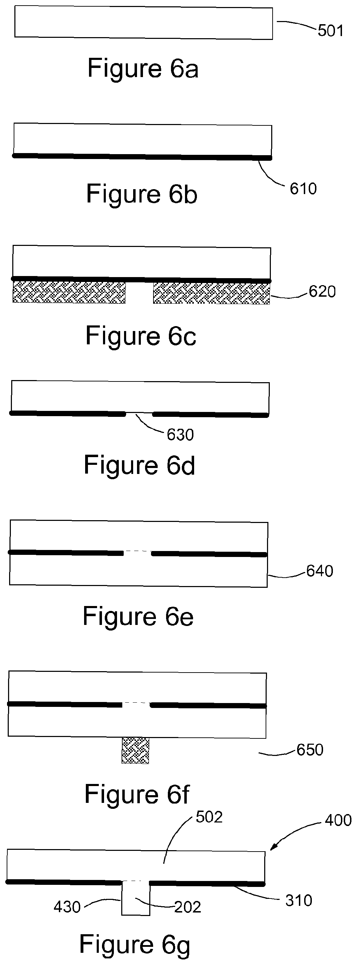

Les figures 6a à 6g décrivent les étapes du mode d'obtention d'un moule de type B.

Comme pour le moule précédent le matériau de départ est un bloc 501 transparent par exemple de quartz sur lequel on dépose la couche, ou la combinaison de couches 610, qui constituera le revêtement de masquage 310 opaque comme illustré en figures 6a et 6b. La couche masque sera faite par exemple de chrome.

Des opérations de photolithographies et de gravures classiques 620 permettent ensuite d'ouvrir la couche masque aux endroits 630 où les reliefs 202 du moule 400 doivent être formés, comme illustré en figures 6b et 6d.

L'opération suivante consiste à déposer un matériau additionnel transparent, par exemple de l'oxyde de silicium, 640 à l'aide de l'une ou l'autre des méthodes de dépôts utilisées couramment par l'industrie de la microélectronique, comme illustré en figure 6e. Préférentiellement, le matériau additionnel 640 transparent recouvre toute la surface.

Par lithographie et gravure on enlève ensuite 650 le second matériau transparent pour créer les reliefs 202 du moule 400 au droit des ouvertures 630 faites précédemment dans la couche masque 610. Ces étapes sont illustrées en figures 6f et 6g.

On obtient ainsi un moule 400 de type B. Les flancs 430 des reliefs 202 ne sont pas recouverts du revêtement de masquage 310.

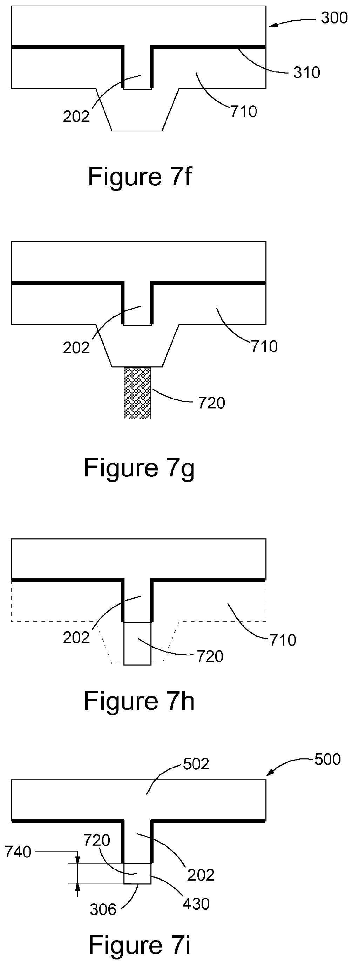

La figure 7 décrit les étapes d'un exemple de procédé d'obtention d'un moule de type C.

A nouveau le matériau de départ est un bloc transparent, par exemple du quartz. Les opérations correspondant aux figures 5a à 5e, et donc à l'obtention d'un moule 300 de type A, sont identiques pour la réalisation d'un moule de type C. Ce qui revient donc à rajouter les étapes des figures 7f à 7i à partir d'un moule 300 de type A.

La première de ces étapes supplémentaires consiste en un dépôt d'un matériau additionnel transparent 710, par exemple de l'oxyde de silicium, sur la face du moule recouverte du revêtement de masquage 310. Cette étape est illustrée en figure 7f.

Ensuite, des opérations classiques de photolithographie et de gravure permettent de laisser en place la seconde couche 710 de matériau transparent sur tous les reliefs 202 du moule.

En particulier, ces étapes comprennent la formation d'un relief d'extension 720 dans une résine, ces reliefs d'extension s'étendant au droit des reliefs 202 formés dans le moule de base 502. La formation de ce relief d'extension 720, obtenu par lithographie, gravure et nettoyage est illustrée en figure 7g et 7h. L'étape de gravure de la figure 7h a pour objet de supprimer la seconde couche 710 en dehors du relief.

Les reliefs 202 du moule 500 final sont donc constitués par la superposition des reliefs du moule 300 de type A obtenu au terme des étapes 5a à 5e et des reliefs d'extension 720.

Les reliefs issus des étapes 5a à 5e ont leurs flancs recouverts de revêtement de masquage 310. Les flancs des reliefs d'extension 720 ne sont pas recouverts de revêtement de masquage 310.

On obtient ainsi un moule 500 de type C dont on peut ajuster, par exemple avec un polissage mécano chimique, la hauteur 740 des reliefs d'extension 720, contrôlant ainsi la hauteur des flancs non recouverte par le revêtement de masquage 740. Le moule 500 ainsi obtenu présente donc des reliefs 202 dont une partie seulement des flancs 430 est recouverte d'un revêtement de masquage 310.

.Chacun des moules 300, 400, 500 est donc obtenu par combinaison d'un substrat laissant passer le rayonnement et d'un revêtement de masquage 310 bloquant au moins en partie ce rayonnement.

Dans tous les modes de réalisation décrits, le revêtement de masquage 310 peut être un revêtement monocouche ou multicouches.

Dans chacun des modes de réalisation, en choisissant une résine adaptée, on pourra remplacer la ou les étapes d'insolation optique par une exposition à un flux d'électrons ou d'ions.

De manière avantageuse, l'invention permet de supprimer les résidus de résine après nano-impression. En outre, elle permet la formation des motifs nanométriques présentant un fort rapport de forme, le rapport de forme étant le rapport entre la hauteur sur la largeur du motif. L'invention est également particulièrement simple et peu onéreuse à mettre en place, le coût d'obtention des moules restant en effet limité.

L'invention n'est pas limitée aux modes de réalisation décrits mais s'étend à tout mode de réalisation entrant dans la portée des revendications.

## Revendications

1. Procédé de lithographie par impression nanométrique comportant une étape de préparation au cours de laquelle on dispose une résine (120) sur un substrat (130), une étape de pressage d'un moule (200, 300, 500) comportant des reliefs (202) de sorte à transférer les reliefs (202) du moule (200, 300, 500) dans la résine (120) pour y former des motifs (230) présentant chacun au moins une extrémité et des flancs, une étape de retrait pour séparer le moule (200, 300, 500) de la résine (120), la résine (120) étant une résine photosensible positive, le procédé comprenant avant ou après l'étape de retrait du moule (200, 300, 500) une étape d'exposition pour activer la résine (120) et comprenant, préalablement à l'étape d'exposition, une étape de masquage au cours de laquelle on dispose entre le moule (200, 300, 500) et la résine (120) un revêtement de masquage (110, 310) stoppant en partie au moins l'exposition de la résine (120) qu'il recouvre de sorte que le revêtement de masquage (110, 310) recouvre toute la résine (120) située en dehors des motifs (230) et laisse libre au moins l'extrémité des motifs (230), **caractérisé en ce que** le revêtement de masquage (110, 310) recouvre une partie au moins des flancs des motifs (230) sur une hauteur strictement supérieure à l'épaisseur du revêtement de masquage (110, 310).

2. Procédé selon la revendication précédente lequel le revêtement de masquage (110, 310) recouvre la résine (120) en dehors des motifs (230) et laisse libre la résine (120) uniquement sur l'extrémité des motifs (230).

3. Procédé selon l'une quelconque des revendications précédentes comprenant une étape de développement de la résine (120) après les étapes d'exposition et de retrait du moule (200, 300, 500).

4. Procédé selon l'une quelconque des revendications précédentes dans lequel le revêtement de masquage (110) est appliqué sur la résine (120) avant l'étape de pressage du moule (200) et dans lequel, lors de l'étape de pressage les reliefs (202) du moule (200) traversent le revêtement de masquage (110) pour pénétrer dans la résine (120).

5. Procédé selon la revendication précédente dans lequel l'étape d'exposition est effectuée après l'étape de retrait du moule (200).

6. Procédé selon l'une quelconque des revendications 4 ou 5 comprenant une étape de développement de la résine (120) après les étapes d'exposition et de retrait du moule (200) et dans lequel le revêtement de masquage (110) est développable et disparaît lors de l'étape du développement de la résine (120).

7. Procédé selon l'une quelconque des revendications 1 à 3 dans lequel le moule (300, 500) est réalisé dans un matériau qui laisse passer au moins en partie le flux d'exposition lors de l'étape d'exposition, dans lequel le revêtement de masquage (310) est appliqué sur le moule (300, 500) avant pressage du moule (300, 500) dans la résine (120) et dans lequel l'étape d'exposition est effectuée avant l'étape de retrait et au travers du moule (300, 500).

8. Procédé selon la revendication précédente dans lequel le revêtement de masquage (310) est appliqué sur le moule (300, 500) de sorte à laisser les reliefs (202) libres au moins à leur extrémité pour permettre une exposition de la résine (120) à travers les reliefs (202) du moule (300, 500).

9. Ensemble multi couches pour la réalisation de motifs (230) dans un substrat (130) par un procédé selon l'une quelconque des revendications 1 à 6, comprenant un substrat (130), une couche de résine (120) apte à se déformer par impression et recouvrant le substrat (130), la résine étant une résine photosensible activable lorsqu'elle est insolée et en ce qu'il comprend un revêtement de masquage (110) recouvrant la couche de résine (120) et stoppant le rayonnement de l'insolation, **caractérisé en ce que** le revêtement de masquage (110) est conformé pour se fendre localement lorsqu'il est pressé par au moins un relief (202) appliqué sur sa surface libre et pénétrant dans la couche de résine (120), de manière à ce que localement, lors de la pénétration de l'au moins un relief (202) le revêtement de masquage (110) se déforme et épouse les formes des reliefs (202) pour recouvrir les flancs des reliefs (202) sur une hauteur strictement supérieure à l'épaisseur de la couche formant le revêtement de masquage 110.

10. Moule (300, 500) pour procédé de lithographie par impression nanométrique comportant un substrat (302, 502) essentiellement transparent au flux d'exposition et présentant une face inférieure munie d'au moins un relief (202) présentant des flancs et une extrémité, un revêtement de masquage (310) situé sur le substrat (302, 502) et configuré pour stopper le flux d'exposition au moins en partie, le revêtement de masquage (310) étant disposé de sorte à laisser libre au moins l'extrémité de l'au moins un relief (202) et à stopper le flux d'exposition en dehors du au moins un relief (202), **caractérisé en ce que** le revêtement de masquage (310) est disposé de sorte à stopper le flux d'exposition sur une partie au moins des flancs (430) du au moins un relief (202), et **en ce que** le revêtement de masquage (110, 310) recouvre les flancs du au moins un relief (202) sur une hauteur strictement supérieure à l'épaisseur du revêtement de masquage (310).

11. Moule (300, 500) selon la revendication 10 dans lequel le revêtement de masquage (310) est recouvert d'un matériau antiadhésif.

12. Moule (300) selon l'une quelconque des revendications 10 ou 11 dans lequel le revêtement de masquage (310) recouvre le substrat (502) et les flancs (430) dudit au moins un relief (202) et laisse passer le flux d'exposition uniquement à l'extrémité dudit au moins un relief (202).

13. Moule (500) selon l'une quelconque des revendications 10 ou 11 dans lequel le revêtement de masquage (310) recouvre le substrat (502) et une partie seulement des flancs (430) dudit au moins un relief (202).

14. Moule (500) selon l'une quelconque des revendications 10 à 13 dans lequel le revêtement de masquage (310) recouvre le substrat (502) et recouvre les flancs (430) du au moins un relief (202) sur une hauteur strictement supérieure à l'épaisseur du revêtement de masquage (310).

15. Moule (500) selon l'une quelconque des revendications 10 à 14 dans lequel le revêtement de masquage (310) recouvre le substrat (502) et au moins 20 % de la hauteur du relief (202).

16. Moule (500) selon la revendication 15 dans lequel le revêtement de masquage (310) recouvre au moins 50 % de la hauteur du relief (202).

17. Procédé de fabrication d'un moule (300, 500) selon l'une quelconque des revendications 10 à 16 comprenant une étape de masquage au cours de laquelle on recouvre une face d'un substrat (501, 502) essentiellement transparent au flux d'exposition avec un revêtement de masquage (310) stoppant le flux d'exposition au moins en partie, au moins une étape de retrait partiel au cours de laquelle on retire partiellement le revêtement de masquage (310) pour définir sur le substrat (501, 502) au moins une zone correspondant à un relief (202) qui est non recouverte par le revêtement de masquage (310) et à travers laquelle le flux d'exposition peut traverser le moule (300, 400, 500) et pour laisser recouverte une partie au moins des flancs (430) des reliefs (202) sur une hauteur strictement supérieure à l'épaisseur du revêtement de masquage (310).

18. Procédé de fabrication d'un moule (300, 500) selon la revendication 17 comprenant, préalablement à l'étape de masquage, une étape d'obtention d'au moins un relief (202) sur ladite face du substrat (502) et dans lequel lors de l'étape de retrait partiel on retire le revêtement de masquage (310) au niveau des extrémités au moins dudit au moins un relief (202).

19. Procédé de fabrication d'un moule (500) selon la revendication 18 dans lequel l'étape de retrait partiel supprime le revêtement de masquage (310) uniquement au niveau de l'extrémité du au moins un relief (202) et comprend une étape d'extension dudit au moins un relief, l'étape d'extension comprenant une sous étape de recouvrement du revêtement de masquage (310) et du moins un relief (202) par un matériau additionnel transparent (710) au flux d'exposition, une sous étape de lithographie effectuée de sorte à supprimer le matériau additionnel (710) en dehors du au moins un relief (202) et à le conserver au niveau du au moins un relief (202) pour former une extension (720) du au moins un relief (202).

## Patentansprüche

1. Nanoprägelithografieverfahren, umfassend einen Vorbereitungsschritt, in dessen Verlauf ein Lack (120) auf einem Substrat (130) angeordnet wird, einen Schritt des Aufprägens einer Erhebungen (202) umfassenden Form (200, 300, 500) derart, dass die Erhebungen (202) der Form (200, 300, 500) in den Lack (120) übertragen werden, um dort Muster (230) zu bilden, die jedes mindestens ein Ende und Flanken aufweisen, einen Schritt des Entfernens, um die Form (200, 300, 500) vom Lack (120) zu trennen, wobei der Lack (120) ein fotoempfindlicher Positivlack ist, wobei das Verfahren vor oder nach dem Schritt des Entfernens der Form (200, 300, 500) einen Belichtungsschritt umfasst, um den Lack (120) zu aktivieren, und vorausgehend zum Belichtungsschritt einen Maskierschritt umfasst, in dessen Verlauf zwischen der Form (200, 300, 500) und dem Lack (120) eine Maskierbeschichtung (110, 310), die die Belichtung des Lacks (120), den sie bedeckt, mindestens zum Teil stoppt, so angeordnet wird, dass die Maskierbeschichtung (110, 310) den ganzen Lack (120), der außerhalb der Muster (230) liegt, bedeckt, und mindestens das Ende der Muster (230) freilässt, **dadurch gekennzeichnet, dass** die Maskierbeschichtung (110, 310) mindestens einen Teil der Flanken der Muster (230) auf einer Höhe bedeckt, die strikt größer ist als die Dicke der Maskierbeschichtung (110, 310).

2. Verfahren nach dem vorstehenden Anspruch, wobei die Maskierbeschichtung (110, 310) den Lack (120) außerhalb der Muster (230) bedeckt und den Lack (120) nur am Ende der Muster (230) freilässt.

3. Verfahren nach einem der vorstehenden Ansprüche, das einen Schritt des Entwickelns des Lacks (120) nach den Schritten der Belichtung und des Entfernens der Form (200, 300, 500) umfasst.

4. Verfahren nach einem der vorstehenden Ansprüche, wobei die Maskierbeschichtung (110) vor dem Schritt des Aufprägens der Form (200) auf den Lack (120) aufgebracht wird, und wobei beim Prägeschritt die Erhebungen (202) der Form (200) die Maskierbeschichtung (110) durchdringen, um in den Lack (120) einzudringen.

5. Verfahren nach dem vorstehenden Anspruch, wobei der Belichtungsschritt nach dem Schritt des Entfernens der Form (200) vorgenommen wird.

6. Verfahren nach einem der Ansprüche 4 oder 5, das einen Schritt des Entwickelns des Lacks (120) nach den Schritten der Belichtung und des Entfernens der Form (200) umfasst, und wobei die Maskierbeschichtung (110) entwickelt werden kann und beim Schritt des Entwickelns des Lacks (120) verschwindet.

7. Verfahren nach einem der Ansprüche 1 bis 3, wobei die Form (300, 500) aus einem Material hergestellt ist, das den Belichtungsstrom beim Belichtungsschritt mindestens zum Teil durchlässt, wobei die Maskierbeschichtung (310) vor Prägen der Form (300, 500) in den Lack (120) auf die Form (300, 500) aufgebracht wird, und wobei der Belichtungsschritt vor dem Schritt des Entfernens der Form (300, 500) und durch dieselbe vorgenommen wird.

8. Verfahren nach dem vorstehenden Anspruch, wobei die Maskierbeschichtung (310) derart auf die Form (300, 500) aufgebracht wird, dass die Erhebungen (202) mindestens an ihrem Ende freigelassen werden, um eine Belichtung des Lacks (120) durch die Erhebungen (202) der Form (300, 500) hindurch zu ermöglichen.

9. Mehrschichtige Anordnung für die Herstellung von Mustern (230) in einem Substrat (130) über ein Verfahren nach einem der Ansprüche 1 bis 6, umfassend ein Substrat (130), eine Lackschicht (120), die sich durch Prägung verformen kann und das Substrat (130) bedeckt, wobei der Lack ein fotoempfindlicher Lack ist, der aktiviert werden kann, wenn er insoliert wird, und dadurch, dass sie eine Maskierbeschichtung (110) umfasst, die die Lackschicht (120) bedeckt und die Strahlung der Insolation stoppt, **dadurch gekennzeichnet, dass** die Maskierbeschichtung (110) dafür ausgebildet ist, sich örtlich zu spalten, wenn sie durch mindestens eine Erhebung (202), die auf ihre freie Fläche aufgebracht wird und in die Lackschicht (120) eindringt, geprägt wird, sodass sich die Maskierbeschichtung (110) beim Eindringen der mindestens einen Erhebung (202) örtlich verformt und an die Formen der Erhebungen (202) anfügt, um die Flanken der Erhebungen (202) auf einer Höhe zu bedecken, die strikt größer ist als die Dicke der Schicht, die die Maskierbeschichtung (110) bildet.

10. Form (300, 500) für ein Nanoprägelithografieverfahren, umfassend ein Substrat (302, 502), das im Wesentlichen für den Belichtungsstrom durchlässig ist und eine untere Seite aufweist, die mit mindestens einer Erhebung (202) ausgestattet ist, welche Flanken und ein Ende aufweist, eine Maskierbeschichtung (310), die auf dem Substrat (302, 502) liegt und dafür konfiguriert ist, den Belichtungsstrom mindestens zum Teil zu stoppen, wobei die Maskierbeschichtung (310) derart angeordnet ist, dass sie mindestens das Ende der mindestens einen Erhebung (202) freilässt und außerhalb der mindestens einen Erhebung (202) den Belichtungsstrom stoppt, **dadurch gekennzeichnet, dass** die Maskierbeschichtung (310) derart angeordnet ist, dass sie den Belichtungsstrom auf mindestens einem Teil der Flanken (430) der mindestens einen Erhebung (202) stoppt, und dadurch, dass die Maskierbeschichtung (110, 310) die Flanken der mindestens einen Erhebung (202) auf einer Höhe bedeckt, die strikt größer ist als die Dicke der Maskierbeschichtung (310).

11. Form (300, 500) nach Anspruch 10, wobei die Maskierbeschichtung (310) mit einem antiadhäsiven Material bedeckt ist.

12. Form (300) nach einem der Ansprüche 10 oder 11, wobei die Maskierbeschichtung (310) das Substrat (502) und die Flanken (430) der mindestens einen Erhebung (202) bedeckt und den Belichtungsstrom nur am Ende der mindestens einen Erhebung (202) durchlässt.

13. Form (500) nach einem der Ansprüche 10 oder 11, wobei die Maskierbeschichtung (310) das Substrat (502) und nur einen Teil der Flanken (430) der mindestens einen Erhebung (202) bedeckt.

14. Form (500) nach einem der Ansprüche 10 bis 13, wobei die Maskierbeschichtung (310) das Substrat (502) bedeckt und die Flanken (430) der mindestens einen Erhebung (202) auf einer Höhe bedeckt, die strikt größer ist als die Dicke der Maskierbeschichtung (310).

15. Form (500) nach einem der Ansprüche 10 bis 14, wobei die Maskierbeschichtung (310) das Substrat (502) und mindestens 20 % der Höhe der Erhebung (202) bedeckt.

16. Form (500) nach Anspruch 15, wobei die Maskierbeschichtung (310) mindestens 50 % der Höhe der Erhebung (202) bedeckt.

17. Verfahren zur Herstellung einer Form (300, 500) nach einem der Ansprüche 10 bis 16, umfassend einen Maskierschritt, in dessen Verlauf eine Seite eines im Wesentlichen für den Belichtungsstrom durchlässigen Substrats (501, 502) mit einer Maskierbeschichtung (310) bedeckt wird, die den Belichtungsstrom mindestens zum Teil stoppt, mindestens einen Schritt des teilweisen Entfernens, in dessen Verlauf die Maskierbeschichtung (310) teilweise entfernt wird, um auf dem Substrat (501, 502) mindestens einen einer Erhebung (202) entsprechenden Bereich zu definieren, der nicht von der Maskierbeschichtung (310) bedeckt ist und durch den hindurch der Belichtungsstrom die Form (300, 400, 500) durchdringen kann, und um mindestens einen Teil der Flanken (430) der Erhebungen (202) auf einer Höhe bedeckt zu lassen, die strikt größer ist als die Dicke der Maskierbeschichtung (310).

18. Verfahren zur Herstellung einer Form (300, 500) nach Anspruch 17, das vorausgehend zum Maskierschritt einen Schritt zum Erhalten von mindestens einer Erhebung (202) auf der Seite des Substrats (502) umfasst, und wobei beim Schritt des teilweisen Entfernens die Maskierbeschichtung (310) mindestens im Bereich der Enden der mindestens einen Erhebung (202) entfernt wird.

19. Verfahren zur Herstellung einer Form (500) nach Anspruch 18, wobei der Schritt des teilweisen Entfernens die Maskierbeschichtung (310) nur im Bereich des Endes der mindestens einen Erhebung (202) beseitigt und einen Schritt des Verlängerns der mindestens einen Erhebung umfasst, wobei der Verlängerungsschritt einen Teilschritt des Bedeckens der Maskierbeschichtung (310) und der mindestens einen Erhebung (202) mit einem zusätzlichen, für den Belichtungsstrom durchlässigen Material (710), einen Lithografie-Teilschritt umfasst, der derart vorgenommen wird, dass das zusätzliche Material (710) außerhalb der mindestens einen Erhebung (202) beseitig und dasselbe im Bereich der mindestens einen Erhebung (202) beibehalten wird, um eine Verlängerung (720) der mindesten einen Erhebung (202) zu bilden.

## Claims

1. Nanoimprint lithography method comprising a preparation step during which a resin (120) is disposed on a substrate (130), a step of pressing a mould (200, 300, 500) comprising reliefs (202) so as to transfer the reliefs (202) of the mould (200, 300, 500) in the resin (120) to form patterns (230) there, each having at least one end and edges, a removal step to separate the mould (200, 300, 500) from the resin (120), the resin (120) being a positive photosensitive resin, the method comprising, before or after the step of removing the mould (200, 300, 500), an exposure step to activate the resin (120) and comprising, prior to the exposure step, a masking step, during which a masking coating (110, 310) is disposed between the mould (200, 300, 500) and the resin (120), partially stopping at least the exposure of the resin (120) that it covers, such that the masking coating (110, 310) covers all the resin (120) located outside of the patterns (230) and leaves free at least the end of the patterns (230), **characterised in that** the masking coating (110, 310) partially covers at least the edges of the patterns (230) over a height, strictly greater than the thickness of the masking coating (110, 310).

2. Method according to the preceding claim, wherein the masking coating (110, 310) covers the resin (120) outside of the patterns (230) and leaves free the resin (120) only on the end of the patterns (230).

3. Method according to any one of the preceding claims, comprising a step of developing the resin (120) after the steps of exposing and removing the mould (200, 300, 500).

4. Method according to any one of the preceding claims, wherein the masking coating (110) is applied on the resin (120) before the step of pressing the mould (200) and wherein, during the pressing step, the reliefs (202) of the mould (200), pass through the masking coating (110) to enter into the resin (120).

5. Method according to the preceding claim, wherein the exposure step is carried out after the step of removing the mould (200).

6. Method according to any one of claims 4 or 5, comprising a step of developing the resin (120) after the steps of exposing and removing the mould (200), and wherein the masking coating (110) can be developed and disappears during the step of developing the resin (120).

7. Method according to any one of claims 1 to 3, wherein the mould (300, 500) is made of a material which lets pass, at least partially the exposure flow during the exposure step, wherein the masking coating (310) is applied on the mould (300, 500) before pressing the mould (300, 500) into the resin (120), and wherein the exposure step is carried out before the removal step and through the mould (300, 500).

8. Method according to the preceding claim, wherein the masking coating (310) is applied on the mould (300, 500) so as to leave the reliefs (202) free at least at the end thereof to make it possible for an exposure of the resin (120) through the reliefs (202) of the mould (300, 500).

9. Multilayer assembly for producing patterns (230) in a substrate (130) by a method according to any one of claims 1 to 6, comprising a substrate (130), a resin layer (120) capable of being deformed by printing and covering the substrate (130), the resin being a photosensitive resin which can be activated when it is insolated and in that it comprises a masking coating (110) covering the resin layer (120) and stopping the radiation from the insolation, **characterised in that** the masking coating (110) is shaped to split locally when it is pressed by at least one relief (202) applied on the free surface thereof and entering into the resin layer (120), such that locally, during the entering of the at least one relief (202), the masking coating (110) is deformed and moulds the shapes of the reliefs (202) to cover the edges of the reliefs (202) over a height strictly greater than the thickness of the layer forming the masking coating (110).

10. Mould (300, 500) for a Nanoimprint lithography method comprising a substrate (302, 502) mainly transparent to the exposure flow and having a lower face equipped with at least one relief (202) having edges and an end, a masking coating (310) located on the substrate (302, 502) is configured to stop the exposure flow at least partially, the masking coating (310) being disposed so as to leave free at least the end of the at least one relief (202) and to stop the exposure flow outside of the at least one relief (202), **characterised in that** the masking coating (310) is disposed so as to stop the exposure flow over at least one portion of the edges (430) of the at least one relief (202), and **in that** the masking coating (110, 310) covers the edges of the at least one relief (202) over a height strictly greater than the thickness of the masking coating (310).

11. Mould (300, 500) according to claim 10, wherein the masking coating (310) is covered by a non-stick material.

12. Mould (300) according to any one of claims 10 or 11, wherein the masking coating (310) covers the substrate (502) and the edges (430) of said at least one relief (202) and lets pass the exposure flow only at the end of said at least one relief (202).

13. Mould (500) according to any one of claims 10 or 11, wherein the masking coating (310) covers the substrate (502) and only one portion of the edges (430) of said at least one relief (202).

14. Mould (500) according to any one of claims 10 to 13, wherein the masking coating (310) covers the substrate (502) and covers the edges (430) of the at least one relief (202) over a height strictly greater than the thickness of the masking coating (310).

15. Mould (500) according to any one of claims 10 to 14, wherein the masking coating (310) covers the substrate (502) and at least 20% of the height of the relief (202).

16. Mould (500) according to claim 15, wherein the masking coating (310) covers at least 50% of the height of the relief (202).

17. Method for producing a mould (300, 500) according to any one of claims 10 to 16, comprising a masking step during which a face of a substrate (501, 502), mainly transparent to the exposure flow is covered with a masking coating (310) stopping the exposure flow at least partially, at least one partial removal step during which the masking coating (310) is partially removed to define on the substrate (501, 502), at least one zone corresponding to a relief (202) which is not covered by the masking coating (310) and through which the exposure flow can pass through the mould (300, 400, 500) and to leave covered at least one portion of the edges (430) of the reliefs (202) over a height strictly greater than the thickness of the masking coating (310).

18. Method for producing a mould (300, 500) according to claim 17, comprising, prior to the masking step, a step of obtaining at least one relief (202), on said face of the substrate (502), and wherein during the partial removal step, the masking coating (310) is removed at the level of the ends at least of said at least one relief (202).

19. Method for producing a mould (500) according to claim 18, wherein the partial removal step removes the masking coating (310) only at the level of the end of the at least one relief (202) and comprises a step of extending said at least one relief, the extension step comprising a sub-step of covering the masking coating (310) and the at least one relief (202) by an additional transparent material (710) at the exposure flow, a lithographic sub-step carried out so as to remove the additional material (710) outside of the at least one relief (202) and to conserve it at the level of the at least one relief (202) to form an extension (720) of the at least one relief (202).
